Europäisches Patentamt

European Patent Office

Office européen des brevets

(11) Veröffentlichungsnummer: **0 042 369**
A1

# EUROPÄISCHE PATENTANMELDUNG

(21) Anmeldenummer: 81890071.4

(22) Anmeldetag: 28.04.81

(51) Int. Cl.³: **H 05 K 9/00,** G 12 B 17/02

(30) Priorität: 13.06.80 AT 3130/80

(71) Anmelder: **SIEMENS AKTIENGESELLSCHAFT ÖSTERREICH, Apostelgasse 12, A-1030 Wien (AT)**

(43) Veröffentlichungstag der Anmeldung: 23.12.81 **Patentblatt 81/51**

(72) Erfinder: **Pohl, Ulrich, Eisteichstrasse 10, A-1110 Wien (AT)**

(84) Benannte Vertragsstaaten: **CH DE GB IT LI**

(74) Vertreter: **Pater, Max, Dr., Apostelgasse 4, A-1030 Wien (AT)**

(54) **Elektromagnetische Abschirmung für Durchtrittsöffnungen.**

(57) Es ist ein dem Querschnitt der Durchtrittsöffnung ausfüllender Kunststoffkörper (1) mit wabenförmigen Durchführungskanälen (4) und einem alle Flächen bedeckenden Metallüberzug (3) vorgesehen.

EP 0 042 369 A1

ACTORUM AG

- 1 -

Elektromagnetische Abschirmung für Durchtrittsöffnungen

Die Erfindung bezieht sich auf eine elektromagnetische Abschirmung für Durchtrittsöffnungen von Gasen oder Flüssigkeiten, insbesondere Luftzuführungsöffnung für elektromagnetisch abgeschirmte Räume.

Zur Belüftung und Klimatisierung von elektromagnetisch abgeschirmten Räumen, die, wie beispielsweise in Spitälern für hochempfindliche Apparate vorzusehen sind, werden Durchführungsöffnungen vorgesehen, die selbst auch eine elektromagnetische Abschirmung aufweisen, um auch Frequenzen in der Größenordnung von 45 GHz und höher von den betreffenden Räumen fernzuhalten. Die bekannten Abschirmungen dieser Art, die speziell für den Frequenzbereich von über 1o GHz vorgesehen wurden, bestehen aus Kupfer- oder Messingröhren oder -Hohlprofilen vorgegebener Länge die einzeln zu einem wabenförmigen Gebilde aneinandergelötet sind, das in die Durchführungsöffnung eingesetzt wird. Die erzielbare Schirmwirkung hängt hierbei vom Verhältnis der Länge zur lichten Weite dieser Profilstücke ab. Die Herstellung solcher Abschirmung in der Weise, daß die miteinander zu verbindenden Teile zuerst durch Verlötung an einzelnen Stellen aneinander fixiert und danach im ganzen durch Tauchverzinnung oder Feuerverzinkung miteinander metallisch überzogen werden, gelingt nur in solchen Fällen, wo die lichten Weiten groß genug sind, daß sich in ihnen das Zinn oder Zink nicht in unkontrollierbarer Weise absetzt und die einzelnen für den Luft- oder Flüssigkeitsdurchtritt vorgesehenen Öffnungen verstopft.

Die Erfindung hat sich die Aufgabe gestellt, eine elektromagnetische Abschirmung für Durchtrittsöffnungen zu schaffen, bei der die Gefahr solcher Verstopfungen nicht besteht und erzielt dies durch einen den Querschnitt der Durchtrittsöffnung angepaßten Kunststoffkörper mit wabenförmig angeordneten Durchführungskanälen, der allseitig mit einer durch Galvanisierung aufgebrachten Metallschicht überzogen ist. Gemäß einem weiteren Merkmal der Erfindung ist der Kunststoffkörper in einen Rahmen eingesetzt und zusammen mit diesem mit einer durch Galvanisierung aufgebrachten Metallschicht überzogen. Dieser Rahmen, der selbst vorzugsweise aus Metall besteht, kann durch HF-dichte Verbindung mit der Raumabschirmung verbunden werden, wodurch eine lückenlose Gesamtabschirmung gewährleistet ist. Die Stärke der durch die Galvanisierung aufgebrachten Metallschicht ist für den Abschirmungseffekt unwesentlich, da zufolge des Skineffektes eine sehr geringe Eindringtiefe zustandekommt.

Ein Ausführungsbeispiel der Erfindung ist in der Zeichnung dargestellt.

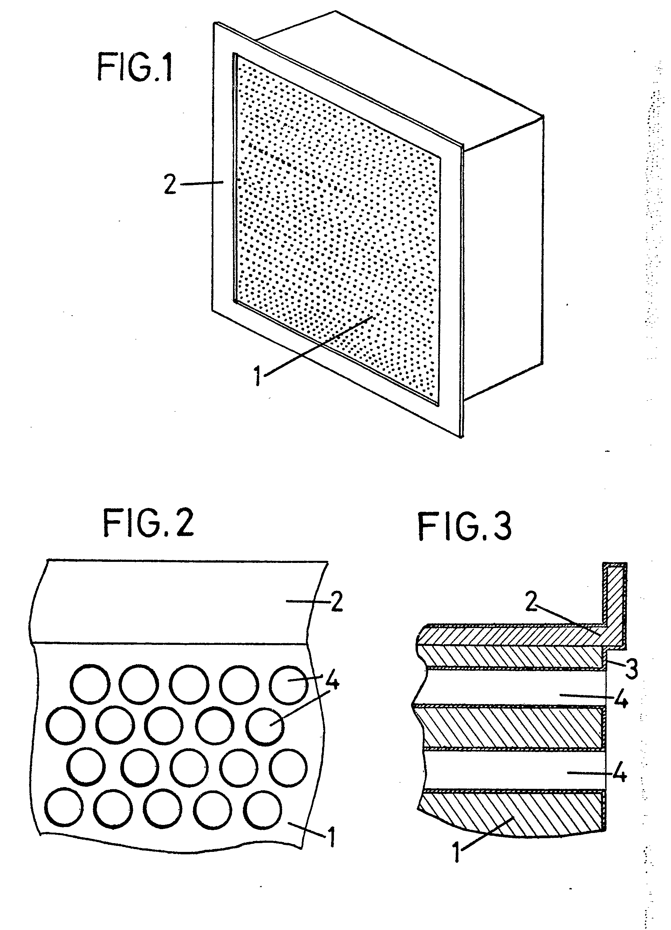

Fig. 1 zeigt in Ansicht eine Abschirmung für eine Durchtrittsöffnung, bestehend aus einem Kunststoffkörper 1 und einem metallischen Rahmen 2.

An Hand eines stark vergrößerten Ausschnittes wird in Fig. 2 in Vorderansicht und in

Fig. 3 im Schnitt ein Teil des Rahmens 2 und des Kunststoffkörpers 1 gezeigt, wobei in Fig. 3 der durch die Galvanisierung aufgebrachte Metallüberzug wesentlich verstärkt dargestellt und mit 3 bezeichnet ist.

Die im Kusntstoffkörper 1 wabenförmig angeordneten Durchführungskanäle 4 weisen z.B. eine lichte Weite von 3 mm auf, wobei die geringste Wandstärke zwischen den Durchführungskanälen 4 etwa 1mm beträgt. Die Stärke des Kunststoffkörpers 1 (= Länge der Durchführungskanäle) liegt, je nach der Größe der abzuschirmenden oberen Grenzfrequenz in der Größenordnung von 5o bis 1oo mm.

- 1 -

Patentansprüche:

1. Elektromagnetische Abschirmung für Durchtrittsöffnungen von Gasen oder Flüssigkeiten, insbesondere Luftzuführungsöffnung für elektromagnetisch abgeschirmte Räume, gekennzeichnet durch einen dem Querschnitt der Durchtrittsöffnung angepaßten Kunststoffkörper (1) mit wabenförmig angeordneten Durchführungskanälen (4), der allseitig mit einer durch Galvanisierung aufgebrachten Metallschicht (3) überzogen ist.

2. Abschirmung nach Anspruch 1, dadurch gekennzeichnet, daß der Kunststoffkörper (1) in einen Rahmen (2) eingesetzt ist und zusammen mit diesem mit einer durch Galvanisierung aufgebrachten Metallschicht (3) überzogen ist.

FIG.1

FIG.2

FIG.3

0042369

Nummer der Anmeldung

EP 81 89 0071

Europäisches
Patentamt

**EUROPÄISCHER RECHERCHENBERICHT**

| | · EINSCHLÄGIGE DOKUMENTE · | | KLASSIFIKATION DER ANMELDUNG (Int. Cl.3) |
|---|---|---|---|
| Kategorie | Kennzeichnung des Dokuments mit Angabe, soweit erforderlich, der maßgeblichen Teile | betrifft Anspruch | |
| X | US - A - 3 446 906 (TEKTRONIX)<br>* Spalte 2, Zeile 52 bis Spalte 4, Zeile 75; Ansprüche; Abbildungen *<br><br>-- | 1,2 | H 05 K 9/00<br>G 12 B 17/02 |
| | DE - A - 2 656 489 (STANDARD ELEKTRIK LORENZ)<br>* Seite 4, Zeile 24 bis Seite 7, Zeile 4; Ansprüche; Abbildungen *<br><br>-- | 1 | |
| | US - A - 3 584 134 (LECTRO MAGNETICS INC.)<br>* Ansprüche; Abbildungen *<br><br>-- | 1 | RECHERCHIERTE SACHGEBIETE (Int. Cl.3)<br><br>H 05 K 9/00<br>G 12 B 17/02 |
| | US - A - 3 546 359 (GICHNER MOBILE SYSTEMS)<br>* Ansprüche; Abbildungnen *<br><br>---- | 1 | |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 22-09-1981 | GORUN |

EPA form 1503.1   06.78